# EUROPEAN PATENT SPECIFICATION

(11) **EP 0 296 747 B1**
(45) Date of publication and mention of the grant of the patent: **17.12.1997**
(21) Application number: 88305407.4
(22) Date of filing: 14.06.1988
(51) Int. Cl.: H01L 21/82, H01L 21/768

(54) **Integrated circuit with tub tie**
Halbleiterschaltung mit Wannenverbindung
Circuit intégré avec connexion du substrat "tub tie"

(30) Priority: 22.06.1987 US 65235
(43) Date of publication of application: 28.12.1988
(73) Proprietor: AT&T Corp., New York, NY 10013-2412 (US)
(72) Inventor: Chen, Min-Liang, Wescosville Pennsylvania 18106 (US); Leung, Chung Wai, Allentown Pennsylvania 18104 (US); Wroge, Daniel Mark, Allentown Pennsylvania 18104 (US)
(74) Representative: Watts, Christopher Malcolm Kelway, Dr.

(56) References cited:
- EP-A- 0 183 032
- SEMICONDUCTOR INTERNATIONAL, May 1985, pages 293-298, New York, US; P. BURGGRAAF: "Silicide technology spotlight"

## Description

### Background of the Invention

### 1. Field of the Invention

The present invention relates to an improved technique for connecting integrated circuit transistors to the doped semiconductor regions in which they are formed. and the integrated circuits formed thereby.

### 2. Description of the Prior Art

In the design of integrated circuits employing field effect transistors, it is frequently necessary to electrically connect a source electrode to the doped semiconductor region in which it is formed. A doped semiconductor region in which transistors are formed, and having a different doping level or type than the semiconductor substrate (or epitaxial layer thereon) in which it is formed, is referred to as a "tub". For example, in complementary field effect device technology, (e.g.. CMOS), the p-channel transistors may be formed in a n-tub connected to the positive power supply voltage (V_{*DD*}), and the n-channel transistors may be formed in a p-tub connected to the negative power supply voltage (V_{*SS*}). The sources of the p-and n-channel transistors are then electrically connected to their respective tubs, in order to receive their respective power supply voltages. One process for forming both p-tubs and n-tubs is disclosed in U.S. Patent 4.435,896 coassigned with the present invention, with others also being known in the art. Furthermore, in some processes, only a single type of tub region is present, being of the opposite conductivity type as the substrate region in which it is formed. Then, the transistors of one conductivity type are formed in the tubs, and the transistors of the opposite conductivity type are formed in the surrounding substrate region. In either the twin tub or the single tub case, the electrical connection between the source and the tub in which it is formed is referred to as a "tub tie".

In order to provide a tub-tie, the prior art provides for opening two contact windows in the dielectric layers overlying both the source region and an adjacent portion of the tub. A low-resistance conductive link, typically aluminum, is then deposited so as to overlie the dielectric material between the windows, and extends into the windows to contact both the source and tub regions. However, this technique requires that space on the integrated circuit be provided for the two contact windows. which is typically greater than the space otherwise required for the device fabrication. An alternative prior art technique utilizes one large contact window, rather than two normal size windows. The large single window provides an opening over both the source and tub regions. A single conductive plug, typically aluminium, is then deposited into the window, thereby electrically connecting the two regions at the bottom of the window. However, this has the disadvantage that the window must be made large enough to ensure that it overlaps both the source and substrate. Typically more area is again required for layout of the circuit than if the tub tie were not present. Furthermore, the non-standard size window complicates the use of computer aided design layout techniques. Therefore, the use of a large single contact window is usually reserved for hand-packed circuit layouts. In the foregoing techniques, to reduce the contact resistance, a more highly doped tub contact region is formed in the tub. before forming the tub tie. For example, a n+ doped region is provided in an n tub, and the contact window opened over the tub contact region, with the tub tie conductor then being deposited.

It is known to decrease the contact resistance to source/drain regions, as well as to the gate electrode, by forming a silicide surface layer thereon. This may be accomplished in a single operation by the so-called "salicide" process. by reacting a refractory metal (e.g., titanium) with the exposed silicon of the source/drain regions, as well as the polysilicon gate electrode; see, for example. "Titanium disilicide self-aligned source/drain + gate technology". C. K. Lau et al. IEDM Technical Digest, pp. 714-717 (1982).

### Summary of the Invention

We have invented an integrated circuit structure as set out in the claims.

The metal silicide layer may be formed on the source region and tub contact region during the same process that forms a metal silicide on the drain and gate. A dielectric layer may be deposited onto the silicide layer, and a window may be formed therein for connecting the source and tub regions to a power supply conductor.

### Brief Description of the Drawing

FIG. 1 shows a cross section of an integrated circuit embodying the invention and
FIG. 2 shows schematically the tub tie connections in a CMOS inverter.

### Detailed Description

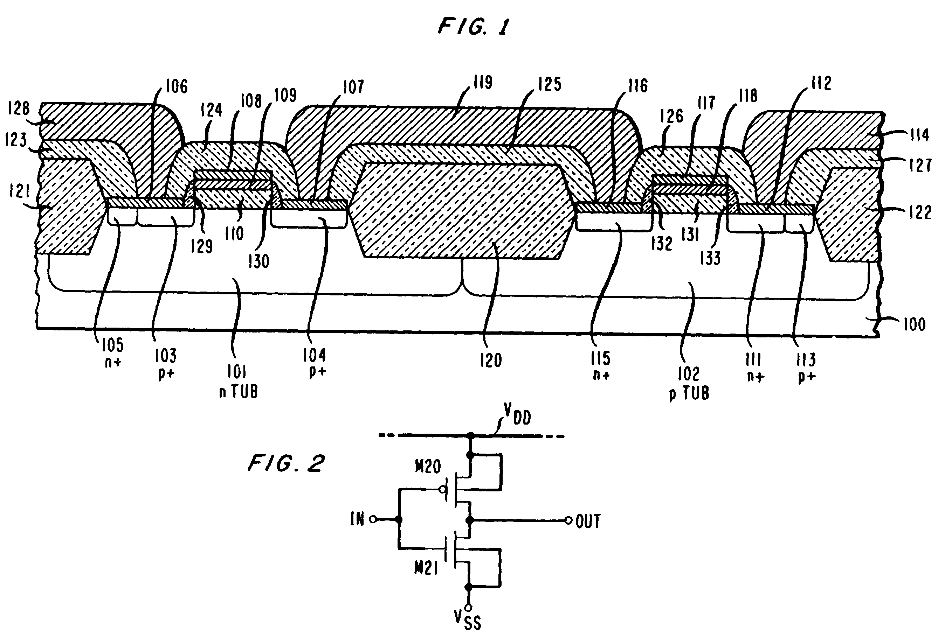

The following detailed description relates to an improved technique for forming an integrated circuit tub tie. Referring to FIG. 1, a cross section of a CMOS inverter utilizing the present technique is illustratively shown. A n tub 101 and p tub 102 are located in a silicon semiconductor body 100. As used herein, the term "tub" means a region formed in the silicon body that has a different conductivity type, or doping level (or both) than the bulk of the silicon body. The body 100 may be a single crystal silicon substrate. or silicon epitaxial layer, with polycrystalline silicon bodies also being possible. Formed in the n tub is a p channel transistor having ρ + source region 103 and drain region 104. Adjacent to source region 103 is a n+ tub contact region 105. In the present technique a metal silicide layer 106 electrically connects source region 103 to the tub contact region 105. and hence to the n tub 101. The metal silicide layer is contacted by a conductor 128. typically aluminium, which connects to a positive power supply voltage. V_{*DD*}. Hence, both the n tub 101 and the source are placed at V_{*DD*} in operation. Metal silicide layers 107 and 108 are also formed on the drain region 104 and polysilicon gate electrode 109, respectively. The gate electrode is insulated from the channel portion of the n tub by gate insulator 110, typically silicon dioxide, with sidewall spacers being optionally included when the lightly-doped drain technique is used to improve transistor reliability in the face of electric field induced degradation.

In the illustrative embodiment, the source 111 of the n channel transistor formed in p tub 102 is similarly connected by metal silicide layer 112 to the ρ + tub contact region 113. Conductor 114 is connected to the negative power supply voltage V_{*SS*}, thereby placing both the source region 111 and the tub 102 at V_{*SS*} in operation. Metal silicide layers 116 and 117 are formed on drain region 115 and polysilicon gate electrode 118. respectively. A conductor 119 connects the drain region 104 and 115 of the p and n channel transistors, respectively. Isolation is provided by field oxide regions 120-122, and the conductors 128, 114, and 119 are insulated from underlying regions by glass layers 123-127.

A typical process sequence for forming the foregoing regions is as follows: The p and n tubs (101, 102) are formed in a silicon water, and the field oxide regions (120-122) formed. The gate oxide regions (110, 118) and n+ polysilicon gate electrodes (109, 117) are patterned. A n- lightly doped drain (LDD) implant is then accomplished for the n-channel transistor, and a p- LDD implant for the p-channel transistor. A silicon dioxide layer is then conformably deposited, and anisotropically etched to form the sidewall spacers (129, 130, 132. 133). The n + and p + source/drain implants for the n- channel and p-channel transistors are then accomplished. followed by a high- temperature anneal. The metal silicide layers 106, 107, 108, 112, 116 and 117 are then formed, by reacting the exposed silicon surfaces of the corresponding regions with a metal. The metal is typically refractory, and in the preferred embodiment it titanium, with others being possible, including tantalum, molybdenum, tungsten, and cobalt.

A typical process known in the art for forming the metal silicide is as follows: A 1000 angstrom (0.1 micrometer) thick layer of titanium was firstly blanket deposited over the regions previously formed on the substrate. A silicon ion beam implant was then accomplished at a 110 keV beam energy, 1X 10¹⁵ *ions/cm*^{*3*} dose. This mixes silicon atoms with the native oxide on the titanium/silicon substrate interface, thereby providing for more consistent formation of the silicide. The titanium was then rapidly thermal annealed at 625 degrees C for 60 seconds in a nitrogen atmosphere, by exposure to a flashlamp. This formed titanium silicide in those regions where the deposited titanium contacted exposed silicon being the source/ drain regions. the tub contact regions, and the gates. The titanium was selectively removed from the other regions (e.g., from over the field oxide and the gate sidewall spacers) by etching in a solution of phosphoric acid and hydrogen peroxide for 9 minutes at 80 degrees C. The silicide was again rapidly thermal annealed in nitrogen, at 900 degrees C for 20 seconds. for improved resistivity. Following the silicide formation, a glass layer was deposited, and windows formed therein. producing regions 123-127. An aluminum layer was then deposited and patterned, forming conductor regions 114, 119 and 128. Still other layers, for example additional dielectric and conductor layers, and oxide or nitride cap layers, may be deposited as desired.

A schematic of the complementary inverter formed as above is shown in FIG. 2. However, the present technique may be applied to transistors in any circuit.

Note also that the present technique does not require opening a contact window at all in order to form the tub tie. For example, a tub tie may be provided for a given number of transistors, and contact windows opened over a fewer number of tub ties, in order to save space. Finally, although the foregoing has been illustrated using insulated gate (e.g.. CMOS) technology, it may also be used for other types, including junction field effect transistor technology.

## Claims

1. An integrated circuit having a first transistor formed in a doped first tub region (101) of a first conductivity type formed in a silicon body (100) of a given conductivity type,
and further comprising a doped second tub region (102) of a second conductivity type opposite to said first conductivity type, with said second tub region abutting said first tub region at a boundary, and still further comprising a field oxide isolation region (120) formed on said boundary at the surface of said silicon body;
wherein a second transistor is formed in said second tub region;
CHARACTERIZED IN THAT
the source (103) of said first transistor is electrically connected to said first tub region by means of a first metal silicide tub tie conductor (106) that contacts said silicon body from said source to an adjacent heavily doped contact region (105) of said first conductivity type formed entirely within said first tub region;
and the source (111) of said second transistor is electrically connected by means of a second tub tie (112) to said second tub region, wherein said second tub tie is a metal silicide that contacts said silicon body from the source of said second transistor to an adjacent heavily doped contact region (113) of said second conductivity type formed entirely within said second tub region.

2. The integrated circuit of claim 1 wherein a dielectric layer (123, 124, 125, 126, 127) overlies portions of said first and second transistors, wherein first and second source contact windows are formed in said dielectric layer, and first and second power supply conductors (128, 114) extend into said source contact windows and contact said first and second tub ties (106, 112).

3. The integrated circuit of claim 1 wherein a multiplicity of transistors are formed in the first and second tub regions so as to have their sources connected by means of metal silicide tub ties to adjacent heavily doped contact regions formed in said tub regions, and wherein a dielectric layer (123, 124, 125, 126, 127) having source contact windows formed therein overlies portions of said transistors, with the number of source contact windows being less than said multiplicity of transistors, whereby the space devoted to source contact windows is reduced.

4. The integrated circuit of claim 1 further comprising a conductor (119) overlying said field oxide isolation region (120) and connecting the drain (104) of said first transistor to the drain (115) of said second transistor, whereby said conductor comprises an output node of an inverter comprising said first and second transistors.

5. The integrated circuit of claim 4 wherein the drains (104, 115) of the first and second transistors are each adjacent to said field oxide isolation region (120).

## Patentansprüche

1. Integrierte Schaltung mit einem ersten Transistor, der in einem dotierten ersten Wannenbereich (101) eines ersten Leitfähigkeitstyps ausgebildet ist, der in einem Siliziumkörper (100) eines gegebenen Leitfähigkeitstyps ausgebildet ist,
und weiterhin mit einem dotierten zweiten Wannenbereich (102) eines zweiten, dem besagten ersten Leitfähigkeitstyp entgegengesetzten Leitfähigkeitstyps, wobei der besagte zweite Wannenbereich an den besagten ersten Wannenbereich an einer Grenze anstößt, und weiterhin mit einem Feldoxid-Isolationsbereich (120), der an der besagten Grenze an der Oberfläche des besagten Siliziumkörpers ausgebildet ist;
wobei in dem besagten zweiten Wannenbereich ein zweiter Transistor ausgebildet ist;
dadurch gekennzeichnet, daß
der Sourceanschluß (103) des besagten ersten Transistors mittels eines ersten Metall-Silizid-Wannenverbindungsleiters (106), der den besagten Siliziumkörper von dem besagten Sourceanschluß zu einem angrenzenden stark dotierten Kontaktbereich (105) des besagten ersten Leitfähigkeitstyps kontaktiert, der ganz innerhalb des besagten ersten Wannenbereichs ausgebildet ist, elektrisch mit dem besagten ersten Wannenbereich verbunden ist;
und der Sourceanschluß (111) des besagten zweiten Transistors mittels eines zweiten Wannenanschlusses (112) elektrisch mit dem besagten zweiten Wannenbereich verbunden ist, wobei der besagte zweite Wannenanschluß ein Metall-Silizid ist, das den besagten Siliziumkörper von dem besagten Sourceanschluß des besagten zweiten Transistors zu einem angrenzenden stark dotierten Kontaktbereich (113) des besagten zweiten Leitfähigkeitstyps kontaktiert, der ganz innerhalb des besagten zweiten Wannenbereichs ausgebildet ist.

2. Integrierte Schaltung nach Anspruch 1, wobei eine dielektrische Schicht (123, 124, 125, 126, 127) Teile des besagten ersten und des besagten zweiten Transistors überdeckt, wobei ein erstes und ein zweites Sourcekontaktfenster in der besagten dielektrischen Schicht ausgebildet werden und sich ein erster und ein zweiter Stromversorgungsleiter (128, 114) in die besagten Sourcekontaktfenster hinein erstrecken und den besagten ersten und die besagte zweite Wannenverbindung (106, 112) kontaktieren.

3. Integrierte Schaltung nach Anspruch 1, wobei eine Mehrzahl von Transistoren in dem ersten und dem zweiten Wannenbereich ausgebildet sind, so daß ihre Sourceanschlüsse durch Metall-Silizid-Wannenverbindungen mit angrenzenden stark dotierten Kontaktbereichen verbunden werden, die in den besagten Wannenausgebildet sind und wobei eine dielektrische Schicht (123, 124, 125, 126, 127) mit darin ausgebildeten Sourcekontaktfenstern Teile der besagten Transistoren überdeckt, wobei die Anzahl von Sourcekontaktfenstern kleiner ist als die besagte Mehrzahl von Transistoren, wodurch der für Sourcekontaktfenster beanspruchte Raum verringert wird.

4. Integrierte Schaltung nach Anspruch 1, weiterhin mit einem Leiter (119), der den besagten Feldoxid-Isolationsbereich (120) überdeckt und den Drainanschluß (104) des ersten Transistors mit dem Drainanschluß (115) des zweiten Transistors verbindet, wodurch der besagte Leiter einen Ausgangsschaltungspunkt eines Inverters umfaßt, der den besagten ersten und den besagten zweiten Transistor umfaßt.

5. Integrierte Schaltung nach Anspruch 4, wobei die Drainanschlüsse (104, 115) des ersten und des zweiten Transistors jeweils an den besagten Feldoxid-Isolationsbereich (120) angrenzen.

## Revendications

1. Circuit intégré ayant un premier transistor formé dans une première région de caisson dopée (101) d'un premier type de conductivité formée dans un corps de silicium (100) d'un type de conductivité donné,
et comprenant en outre une deuxième région de caisson dopée (102) d'un deuxième type de conductivité opposé audit premier type de conductivité, ladite deuxième région de caisson jouxtant ladite première région de caisson, et comprenant aussi en plus une région d'isolement d'oxyde épais (120) formée sur ladite limite au niveau de la surface dudit corps de silicium;
dans lequel un deuxième transistor est formé dans ladite deuxième région de caisson;
CARACTERISE EN CE QUE
la source (103) dudit premier transistor est connectée électriquement à ladite première région de caisson au moyen d'un premier conducteur de type "tub tie" en siliciure métallique (106) qui contacte ledit corps de silicium depuis ladite source jusqu'à une région de contact fortement dopée adjacente (105) dudit premier type de conductivité formée entièrement à l'intérieur de ladite première région de caisson;
et la source (111) dudit deuxième transistor est électriquement connectée au moyen d'un deuxième "tub tie" (112) à ladite deuxième région de caisson, dans lequel ledit deuxième "tub tie" est un siliciure métallique qui contacte ledit corps de silicium depuis la source dudit deuxième transistor jusqu'à une région de contact fortement dopée adjacente (113) dudit deuxième type de conductivité formé entièrement à l'intérieur de ladite deuxième région de caisson.

2. Circuit intégré selon la revendication 1, dans lequel une couche diélectrique (123, 124, 125, 126, 127) recouvre des parties desdits premier et deuxième transistors, dans lequel des première et deuxième fenêtres de contact de source sont formées dans ladite couche diélectrique, et des premier et deuxième conducteurs d'alimentation (128, 114) s'étendent dans lesdites fenêtres de contact de source et contactent lesdits premier et deuxième "tub tie" (106, 112).

3. Circuit intégré selon la revendication 1, dans lequel une multiplicité de transistors sont formés dans les première et deuxième régions de caisson de manière à ce que leurs sources soient connectées au moyen de "tub tie" en siliciure métallique à des régions de contact fortement dopées adjacentes formées dans lesdites régions de caisson, et dans lequel une couche diélectrique (123, 124, 125, 126, 127) dans laquelle sont formées des fenêtres de contact de source recouvre des parties desdits transistors, le nombre de fenêtres de contact de source étant inférieur à ladite multiplicité de transistors, si bien que l'espace consacré aux fenêtres de contact de source est réduit.

4. Circuit intégré selon la revendication 1, comprenant en outre un conducteur (119) recouvrant ladite région d'isolement d'oxyde épais (120) et connectant le drain (104) dudit premier transistor au drain (115) dudit deuxième transistor, si bien que ledit conducteur comprend un noeud de sortie d'un inverseur comprenant lesdits premier et deuxième transistors.

5. Circuit intégré selon la revendication 4, dans lequel les drains (104, 115) des premier et deuxième transistors sont chacun adjacents à ladite région d'isolement d'oxyde épais (120).
